# EUROPÄISCHE PATENTSCHRIFT

(11) **EP 0 875 062 B1**
(45) Veröffentlichungstag und Bekanntmachung des Hinweises auf die Patenterteilung: **04.02.2004**
(21) Anmeldenummer: 97951062.5
(22) Anmeldetag: 11.11.1997
(51) Int. Cl.: G11C 5/00, G11C 7/00

(54) **ZUR ABARBEITUNG VON SOFTWAREPROGRAMMEN AUSGELEGTE INTEGRIERTE SCHALTUNG**
INTEGRATED CIRCUIT DESIGNED FOR PROCESSING SOFTWARE PROGRAMS
CIRCUIT INTEGRE CON U POUR PRENDRE EN CHARGE DES PROGRAMMES LOGICIELS

(30) Priorität: 14.11.1996 DE 19647181
(43) Veröffentlichungstag der Anmeldung: 04.11.1998
(73) Patentinhaber: Infineon Technologies AG, 81669 München (DE)
(72) Erfinder: FÖDLMEIER, Dieter, D-84032 Altdorf (DE); STÜTING, Udo, D-85716 Unterschleissheim (DE); BRACHMANN, Bernd, D-86971 Peiting (DE)
(74) Vertreter: Jannig, Peter, Dipl.-Ing.
(86) Internationale Anmeldenummer: PCT/DE1997/002632
(87) Internationale Veröffentlichungsnummer: WO 1998/021725

(56) Entgegenhaltungen:
- EP-A- 0 009 862
- WO-A-92/08671
- WO-A-92/15966
- WO-A-94/06077
- WO-A-97/31311
- US-A- 4 990 800
- US-A- 5 109 503
- US-A- 5 161 124

## Beschreibung

Zur Abarbeitung von Softwareprogrammen ausgelegte integrierte Schaltung

Die vorliegende Erfindung betrifft eine integrierte Schaltung gemäß dem Oberbegriff des Patentanspruchs 1, d.h. eine zur Abarbeitung von Softwareprogrammen ausgelegte integrierte Schaltung.

Derartige integrierte Schaltungen sind insbesondere in Mikroprozessoren, Mikrocontrollern, Signalprozessoren und dergleichen enthalten; sie existieren in einer Vielzahl verschiedenster Ausführungsformen und sind bekanntermaßen weit verbreitet.

Obgleich Mikroprozessoren, Mikrocontroller, Signalprozessoren und dergleichen in den unterschiedlichsten Ausführungsformen erhältlich sind (oder vielleicht auch gerade deshalb), ist es schwierig oder bisweilen sogar unmöglich, einen Typen zu finden, der die im konkreten Einzelfall gestellten Anforderungen (und nur diese) erfüllen kann.

Wird ein Mikroprozessor, Mikrocontroller, Signalprozessor oder dergleichen ausgewählt, welcher - aus welchem Grund auch immer - nicht alle der gestellten Anforderungen erfüllen kann, so wird dadurch in der Regel die Hardware aufwendiger, innerhalb welcher derselbe eingesetzt werden soll.

Wird andererseits ein Mikroprozessor, Mikrocontroller, Signalprozessor oder dergleichen ausgewählt, welcher mehr als gefordert leisten kann, so steigt dadurch in der Regel der Preis des denselben enthaltenden Produkts.

Aus der EP 0 009 862 ist eine schaltung gemäß dem Oberbegriff des Anspruchs 1 bekannt, bei der eine Konfigurierung der Ein- /Ausgabeanschlüsse während des Resets der Schaltung erfolgt.

Der vorliegenden Erfindung liegt daher die Aufgabe zugrunde, die integrierte Schaltung gemäß dem Oberbegriff des Patentanspruchs 1 derart weiterzubilden, daß diese für eine große Anzahl unterschiedlichster Anwendungsfälle jeweils optimal einsetzbar ist.

Diese Aufgabe wird erfindungsgemäß durch die im kennzeichnenden Teil des Patentanspruchs 1 beanspruchten Merkmale gelöst.

Demnach ist vorgesehen, daß die elektronischen Bauelemente der integrierten Schaltung und/oder die zwischen diesen vorgesehenen elektrischen Verbindungen zumindest teilweise derart ausgebildet sind, daß die Verschaltung der elektronischen Bauelemente und/oder deren Funktion und/oder Wirkungsweise insbesondere durch selektives Auftrennen und/oder Schaffen von Verbindungen zumindest teilweise individuell konfigurierbar sind, wobei die Konfigurierung der Verbindungen dynamisch und parallel während des Betriebes der integrierten Schaltung erfolgt.

Eine derartige integrierte Schaltung ist dadurch anders als herkömmliche integrierte Schaltungen der betrachteten Art hardwaremäßig konfigurierbar.

Diese hardwaremäßige Konfigurierbarkeit erlaubt es, die integrierte Schaltung nahezu beliebig an die jeweilig gewünschten Gegebenheiten anzupassen. Diese Anpassung erfolgt dynamisch während der Laufzeit der integrierten Schaltung. Vorteilhafterweise erfolgt die Konfigurierung der Verbindungen intern durch die integrierte Schaltung selbst. Durch die dynamische sowie interne Konfiguration der Verbindungen läßt sich die integrierte Schaltung, ohne daß der Betrieb der integrierten Schaltung unterbrochen werden muß, an die jeweiligen Anforderungen anpassen.

Sieht man beispielsweise den die Softwareprogramme abarbeitenden Teil der integrierten Schaltung als intelligenten Kern derselben vor und ordnet zwischen diesem und den Ein- und/oder Ausgabeanschlüssen (Pins) der integrierten Schaltung einen hardwaremäßig konfigurierbaren Teil derselben an, so können durch den Benutzer beliebige Ein- und/oder Ausgabeanschlüsse mit beliebigen Funktionen belegt werden. Dadurch können, um nur eines von nahezu unbeschränkt vielen Beispielen zu nennen, beliebig viele Pins als Ein- und/oder Ausgabeanschlüsse für beliebig viele serielle oder parallele Schnittstellen konfiguriert werden.

Zusätzlich kann vorgesehen werden, zumindest Teile des intelligenten Kerns hardwaremäßig konfigurierbar zu gestalten. Auf diese Weise können die Funktion und die Wirkungsweise des intelligenten Kerns beeinflußt werden, was sich, um wiederum nur eines von nahezu unbeschränkt vielen Beispielen zu nennen, zur Auswahl, Beeinflussung und/oder Kreierung des Befehlsdecoders (individuelle Anpassung an einen vom Benutzer gewünschten Befehlssatz) ausnutzen läßt.

Der intelligente Kern ist dabei als Zustandsautomat anzusehen. Dieser Zustandsautomat weist eine vorgegebene Menge von Zuständen auf, die in einem fest vorgegebenen Schema ablaufen. Insbesondere kann der intelligente Kern beispielsweise durch mindestens Microcontroller, Microprocessor, digitaler Signalprozessor oder ähnlichem realisiert sein.

Der Peripheriebereich kann durch eine Anzahl von programmierbaren Gatterelementen, wie beispielsweise FPGAs, PLDs, PLAs oder ähnlichem gebildet sein. Besonders vorteilhaft ist es auch, wenn der Pheripheriebereich durch mindestens einen Co-Prozessor gebildet wird, der dem intelligenten Kern dynamisch dazugeschaltet wird, falls dieser beispielsweise zusätzliche Rechenleistung benötigt bzw. wenn Daten sachneller verarbeitet werden sollen.

Allgemein gesagt ermöglicht die hardwaremäßige Konfigurierbarkeit einer zur Abarbeitung von Softwareprogrammen ausgelegten integrierten Schaltung deren Anpassung an die unterschiedlichsten Anforderungen.

Es wurde mithin eine integrierte Schaltung geschaffen, welche für eine große Anzahl unterschiedlichster Anwendungsfälle jeweils optimal einsetzbar ist.

Vorteilhafte Weiterbildungen der Erfindung sind Gegenstand der Unteransprüche.

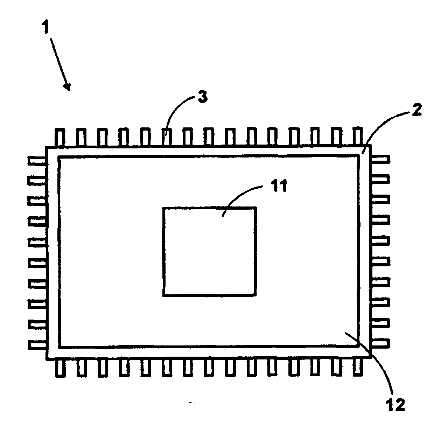

Die Erfindung wird nachfolgend anhand eines Ausführungsbeispiels unter Bezugnahme auf die Zeichnung näher erläutert.

Die Figur zeigt eine schematische Darstellung einer erfindungsgemäß ausgebildeten integrierten Schaltung.

Die in der Figur gezeigte und im folgenden näher beschriebene integrierte Schaltung ist in der Figur mit dem Bezugszeichen 1 bezeichnet.

Die integrierte Schaltung 1 ist in einem Gehäuse 2 mit einer Vielzahl von Ein- und/oder Ausgabeanschlüssen bzw. Pins 3 untergebracht; sie kann jedoch auch als gehäuseloser Chip eingesetzt werden oder in beliebigen anderen Gehäusen untergebracht sein.

Die in der Figur gezeigte integrierte Schaltung 1 besteht aus einem Kernbereich 11 und einem Peripheriebereich 12.

Der Kernbereich 11 ist ein zur Abarbeitung von Softwareprogrammen ausgelegter Bereich der integrierten Schaltung, der bezüglich der Funktion und Wirkungsweise dem intelligenten Kern eines Mikroprozessors, Mikrocontrollers, Signalprozessors oder dergleichen entspricht.

Der den Kernbereich 11 umgebende Peripheriebereich 12 stellt die Verbindung zwischen dem Kernbereich 11 und den Einund/oder Ausgabeanschlüssen 3 dar. Er besteht aus einer Vielzahl von insbesondere Gatter repräsentierenden elektronischen Bauelementen, deren Verschaltung und/oder deren Funktion und/oder Wirkungsweise insbesondere durch selektives Auftrennen und/oder Schaffen von Verbindungen zwischen den elektronischen Bauelementen zumindest teilweise individuell konfigurierbar sind.

Das Auftrennen und/oder Schaffen von elektrischen Verbindungen zwischen den Bauelementen des Peripheriebereichs bzw. den durch diese gebildeten Gattern 12 kann auf unterschiedlichste Art und Weise bewerkstelligt werden.

Eine der Möglichkeiten zum Auftrennen von Verbindungen besteht darin, daß im Verbindungsweg vorgesehene Schmelzsicherungen (Fuses) oder dergleichen durch einen entsprechend hohen elektrischen Stromfluß zum Schmelzen gebracht werden.

Eine weitere Möglichkeit zum Auftrennen von Verbindungen besteht im Vorsehen von als Schaltelemente oder in Schaltelementen verwendeten nicht flüchtigen Speicherelementen wie beispielsweise ROM-, EPROM, EEPROM, Flash-EPROM-Zellen oder dergleichen; die Verbindung, deren Zustand (durchgängig oder aufgetrennt) hier von dem im jeweiligen Speicherelement gespeicherten Wert abhängig machbar ist, kann in diesem Fall nicht nur getrennt, sondern auch neu erzeugt bzw. wiederhergestellt werden.

Das Schaffen einer neuen dauerhaften Verbindung zwischen zwei zu verbindenden Bauelementen kann auch dadurch bewerkstelligt werden, daß ein zwischen den zu verbindenden Bauelementen vorgesehenes weiteres Bauelement definiert derart zerstört wird, daß dadurch eine durchgehende Verbindung zwischen den zu verbindenden Bauelementen geschaffen wird.

Die vorstehend genannten Möglichkeiten zum Auftrennen und/oder Schaffen von elektrischen Verbindungen zwischen Bauelementen repräsentieren nur einen Teil der hierfür geeigneten Möglichkeiten; es sind noch alternative und/oder ergänzende Möglichkeiten bekannt und denkbar.

Die Konfigurierung der integrierten Schaltung muß nicht unbedingt (allein) durch Auftrennen und/oder Schaffen von elektrischen Verbindungen erfolgen. Zusätzlich oder alternativ kann vorgesehen werden, die elektronischen Bauelemente der integrierten Schaltung durch eine nicht flüchtige Betriebsarteinstellung, eine gezielte Teilzerstörung oder dergleichen selektiv in ihrer Funktion und Wirkungsweise zu beeinflussen.

Bezüglich der Art und Weise, in der die elektronischen Bauelemente der integrierten Schaltung und/oder die Verbindungen zwischen diesen auszubilden sind, um hardwaremäßig konfigurierbar zu sein, und bezüglich der Art und Weise, auf welche die integrierte Schaltung letztlich hardwaremäßig konfiguriert wird, wird ergänzend auf die Maßnahmen verwiesen, die für diese oder ähnliche Zwecke bei den bekannten programmierbaren Logiken wie etwa PLAs (programmable logical arrays), GALs (gate array logic), PLDs (programmable logic arrays), FPGAs (field programmable gate arrays) und dergleichen vorgesehen werden; die von den hardwaremäßig konfigurierbaren Logiken her bekannten Maßnahmen zur hardwaremäßigen Konfigurierung derselben sind grundsätzlich auch zur Konfigurierung der erfindungsgemäßen integrierten Schaltung einsetzbar.

Die Konfigurierung der betrachteten integrierten Schaltung 1 erfolgt erst nach der Herstellung der integrierten Schaltung und deren Unterbringung in einem Gehäuse, und zwar vorzugsweise elektrisch durch Anlegen entsprechender Spannungen oder Signale an vorbestimmte Ein- und/oder Ausgabeanschlüsse 3. Zusätzlich oder alternativ können hierbei jedoch auch optische Verfahren (unter Verwendung von UV-Licht, Laserstrahlen oder dergleichen) oder sonstige Verfahren zum Einsatz kommen

Die Konfigurierung der integrierten Schaltung 1 erfolgt beispielsweise unter Verwendung einer Hardwareprogrammierungssprache wie VHDL oder dergleichen.

Durch die Konfigurierung des Peripheriebereiches 12 können zwischen den einzelnen Ein- und/oder Ausgabeanschlüssen 3 und dem die Softwareprogramme abarbeitenden intelligenten Kern im (logisch gesehen) zentralen Kernbereich 11 der integrierten Schaltung Verbindungen hergestellt werden, die über mehr oder weniger beliebig viele und beliebig verschaltete Bauelemente bzw. Gatter verlaufen können und den Kernbereich 11 an mehr oder weniger beliebigen Stellen erreichen können.

Dies eröffnet die Möglichkeit, die einzelnen Ein- und/oder Ausgabeanschlüsse individuell mit Funktionen zu belegen, die optimal an die jeweiligen Bedürfnisse des Benutzers der integrierten Schaltung angepaßt sind. So können beispielsweise innerhalb gewisser Grenzen beliebig viele serielle und/oder parallele Schnittstellen (I/O-Interfaces) vorgesehen werden.

Daneben können die Bauelemente des Peripheriebereiches 12 bzw. die durch diese gebildeten Gatter so verschaltet werden, daß im Peripheriebereich eine Vorverarbeitung und/oder eine Nachbearbeitung der über die Ein- und/oder Ausgabeanschlüsse 3 eingegebenen und/oder auszugebenden Signale oder Daten durchführbar ist. Dadurch kann beispielsweise erreicht werden, daß im Peripheriebereich 12 eine Codierung und/oder Decodierung von eingegebenen bzw. auszugebenden Signalen oder Daten durchgeführt wird.

Im Peripheriebereich 12 durchgeführte Daten- oder Signalverarbeitungen sind mit einer Geschwindigkeit durchführbar, welche in aller Regel erheblich höher ist als die Geschwindigkeit, die erzielbar wäre, wenn die Verarbeitung unter Softwaresteuerung im intelligenten Kern ausgeführt würde. Andererseits läßt sich durch die Verlagerung der genannten Verarbeitungen in die integrierte Schaltung die Hardware, in welche die integrierte Schaltung einzubetten ist, zum Teil erheblich vereinfachen.

Ergänzend kann vorgesehen werden, nicht nur den Peripheriebereich 12, sondern auch den Kernbereich 11 auf die beschriebene Art und weise hardwaremäßig konfigurierbar zu gestalten. Dadurch kann beispielsweise der Befehlsdecoder des intelligenten Kerns konfiguriert oder einer von mehreren Befehlsdecodern ausgewählt werden, wodurch sich im Gegensatz zu den bisher bekannten Mikroprozessoren, Mikrocontrollern und Signalprozessoren deren Befehlssatz individuell festlegen und/oder verändern läßt.

Die vorstehend angesprochenen, sich aus der hardwaremäßigen Konfigurierbarkeit des Kernbereichs 11 und/oder des Peripheriebereichs 12 der integrierten Schaltung ergebenden Möglichkeiten zur Einflußnahme auf deren Funktion und/oder Wirkungsweise sind nur einige wenige, zur Veranschaulichung dienende Beispiele. Das Vorsehen einer hardwaremäßigen Konfigurierbarkeit einer zur Abarbeitung von Softwareprogrammen ausgelegten integrierten Schaltung eröffnet grundsätzlich die Möglichkeit, diese in nahezu all ihren technischen Eigenschaften an die individuellen Bedürfnisse anzupassen.

Obgleich die beschriebene integrierte Schaltung komplizierter als herkömmliche, d.h. nicht hardwaremäßig konfigurierbare integrierte Schaltungen aufgebaut ist, dürfte diese in der Herstellung nicht teurer sein. Bedingt durch die Tatsache, daß ein- und dieselbe integrierte Schaltung durch hardwaremäßige Konfigurierung nahezu beliebig an die individuellen Bedürfnisse anpaßbar ist, kann sie in enorm großen Stückzahlen hergestellt werden, was den Nachteil des komplizierten Aufbaus in wirtschaftlicher Hinsicht ohne weiteres kompensiert.

Zusammenfassend kann festgestellt werden, daß mit der beschriebenen, zur Abarbeitung von Softwareprogrammen ausgelegten integrierten Schaltung für eine große Anzahl unterschiedlichster Anwendungsfälle sowohl in wirtschaftlicher als auch in technischer Hinsicht jeweils optimal einsetzbar ist.

## Patentansprüche

1. Zur Abarbeitung von Softwareprogrammen ausgelegte integrierte Schaltung (1), mit einem die Softwareprogramme abarbeitenden Kernbereich (11) und einem zwischen dem Kernbereich (11) und Ein- und/oder Ausgabeanschlüssen (3) der integrierten Schaltung (1) vorgesehenen Peripheriebereich (12),
**dadurch gekennzeichnet**
- **daß** der Peripheriebereich eine programmierbare Logik enthält, wobei die elektronischen Bauelemente der programmierbaren Logik und/oder die zwischen diesen vorgesehenen elektrischen Verbindungen zumindest teilweise derart ausgebildet sind, daß die Verschaltung der elektronischen Bauelemente und/oder deren Funktion und/oder Wirkungsweise durch selektives Auftrennen und/oder Schaffen von Verbindungen zumindest teilweise individuell konfigurierbar sind, und
- **daß** die Konfigurierung der Verbindungen dynamisch und parallel während des Betriebes der integrierten Schaltung (1) erfolgt.

2. Integrierte Schaltung nach Anspruch 1,
**dadurch gekennzeichnet,**
**daß** die Konfigurierung der Verbindungen intern durch die integrierte Schaltung (1) erfolgt.

3. Integrierte Schaltung nach einem der vorhergenden Ansprüche,
**dadurch gekennzeichnet**
**daß** der Peripheriebereich (12) derart konfigurierbar ist, daß die Ein- und/oder Ausgabeanschlüsse (3) der integrierten Schaltung (1) zumindest teilweise individuell belegbar sind.

4. Integrierte Schaltung nach einem der vorhergehenden Ansprüche,
**dadurch gekennzeichnet,**
**daß** der Peripheriebereich (12) derart konfigurierbar ist, daß in diesem eine Vorverarbeitung und/oder eine Nachbearbeitung von über die Ein- und/oder Ausgabeanschlüsse (3) eingegebenen und/oder auszugebenden Signale oder Daten durchführbar ist.

5. Integrierte Schaltung nach einem der vorhergehenden Ansprüche,
**dadurch gekennzeichnet,**
**daß** der Kernbereich (11) derart konfigurierbar ist, daß die von diesem ausführbaren Befehle individuell festlegbar und/oder veränderbar sind.

6. Integrierte Schaltung nach einem der vorhergehenden Ansprüche,
**dadurch gekennzeichnet,**
**daß** der Kernbereich (11) mindestens einen Mikroprozessor und/oder mindestens einen Mikrocontroller und/oder mindestens einen Signalprozessor mit einer vorgegebenen Menge von Zuständen enthält.

7. Integrierte Schaltung nach einem der vorhergehenden Ansprüche,
**dadurch gekennzeichnet,**
**daß** der Peripheriebereich (12) mindestens einen dem Kernbereich (11) zuschaltbaren Co-Prozessor enthält.

8. Integrierte Schaltung nach einem der vorhergehenden Ansprüche,
**dadurch gekennzeichnet,**
**daß** der Peripheriebereich (12) eine Mehrzahl von programmierbaren Gatterelementen enthält.

## Claims

1. Integrated circuit (1) designed for the execution of software programs and having a core region (11), which executes the software programs, and a peripheral region (12) provided between the core region (11) and input and/or output terminals (3) of the integrated circuit (1), **characterized in that** the peripheral region comprises programmable logic, where the electronic components of the programmable logic and/or the electrical connections provided between them are at least in part arranged in such a way that the interconnection of the electronic components and/or their function and/or mode of action can be at least in part individually configured by selectively breaking and/or making connections, and - **in that** the configuration of the connections is carried out dynamically and in parallel during the operation of the integrated circuit (1).

2. Integrated circuit according to Claim 1, **characterized in that** the configuration of the connections is carried out internally by the integrated circuit (1).

3. Integrated circuit according to one of the preceding claims, **characterized in that**, the peripheral region (12) can be configured in such a way that the input and/or output terminals (3) of the integrated circuit (1) can at least in part be individually allocated.

4. Integrated circuit according to one of the preceding claims, **characterized in that** the peripheral region (12) can be configured in such a way that preprocessing and/or postprocessing of signals or data which are input and/or are to be output via the input and/or output terminals (3) can be performed in it.

5. Integrated circuit according to one of the preceding claims, **characterized in that** the core region (11) can be configured in such a way that the instructions that it can carry out can be individually established and/or changed.

6. Integrated circuit according to one of the preceding claims, **characterized in that** the core region (11) contains at least one microprocessor and/or at least one microcontroller and/or at least one signal processor having a predetermined number of states.

7. Integrated circuit according to one of the preceding claims, **characterized in that** the peripheral region (12) contains at least one coprocessor which can be connected to the core region (11).

8. Integrated circuit according to one of the preceding claims **characterized in that** the peripheral region (12) contains a multiplicity of programmable gate elements.

## Revendications

1. Circuit intégré (1) conçu pour le traitement de programmes logiciels, avec une zone noyau (11) traitant les programmes logiciels et une zone périphérique (12) prévue entre la zone noyau (11) et les connexions d'entrée et/ou de sortie (3) du circuit intégré (1),
**caractérisé en ce que**
- la zone périphérique comprend une logique programmable, les composants électroniques de la logique programmable et/ou les connexions électriques prévues entre ceux-ci étant formés au moins en partie de sorte que le câblage des composants électroniques et/ou leur fonction et/ou leur fonctionnement soient configurables individuellement, au moins en partie, par interruption et/ou création sélective de connexions, et
- **en ce que** la configuration des connexions s'effectue de manière dynamique et parallèle pendant le fonctionnement du circuit intégré (1).

2. Circuit intégré selon la revendication 1,
**caractérisé en ce que**
la configuration des connexions s'effectue en interne par le circuit intégré (1).

3. Circuit intégré selon l'une des revendications précédentes,
**caractérisé en ce que**
la zone périphérique (12) est configurable de telle sorte que les connexions d'entrée et/ou de sortie (3) du circuit intégré (1) peuvent être affectées au moins en partie individuellement.

4. Circuit intégré selon l'une des revendications précédentes,
**caractérisé en ce que**
la zone périphérique (12) est configurable de telle sorte qu'un prétraitement et/ou un post-traitement de signaux ou de données acquis et/ou à émettre par l'intermédiaire des connexions d'entrée et/ou de sortie (3) est réalisable dans cette zone.

5. Circuit intégré selon l'une des revendications précédentes,
**caractérisé en ce que**
la zone noyau (11) est configurable de telle sorte que les instructions qu'elle peut exécuter peuvent être définies et/ou modifiées individuellement.

6. Circuit intégré selon l'une des revendications précédentes,
**caractérisé en ce que**
la zone noyau (11) comporte au moins un microprocesseur et/ou au moins un microcontrôleur et/ou au moins un processeur de signaux avec un nombre prédéfini d'états.

7. Circuit intégré selon l'une des revendications précédentes,
**caractérisé en ce que**
la zone périphérique (12) comporte au moins un coprocesseur pouvant être adjoint à la zone noyau (11).

8. Circuit intégré selon l'une des revendications précédentes,
**caractérisé en ce que**
la zone périphérique (12) comporte une pluralité d'éléments de portes logiques programmables.
